# EUROPEAN PATENT APPLICATION

(11) **EP 2 953 179 A1**
(43) Date of publication of application: **09.12.2015**
(21) Application number: 13873695.4
(22) Date of filing: 31.01.2013
(51) Int. Cl.: H01L 51/50, H05B 33/02, H05B 33/10

(54) **LIGHT-EMITTING ELEMENT AND PRODUCTION METHOD FOR LIGHT-EMITTING ELEMENT**

(71) Applicant: Pioneer Corporation, Kawasaki-shi, Kanagawa 212-0031 (JP)
(72) Inventor: KURODA Kazuo, Kawasaki-shi Kanagawa 212-0031 (JP)
(74) Representative: Vossius & Partner Patentanwälte Rechtsanwälte mbB
(86) International application number: PCT/JP2013/052186
(87) International publication number: WO 2014/118936

(57) **Abstract**

A light emitting element (100) includes a light transmissive substrate (110), a light emitting layer arranged on a side opposite to a light extraction side based on the light transmissive substrate (110), and a diffraction grating layer (120) arranged on a side opposite to the light extraction side based on the light transmissive substrate (110). The diffraction grating layer (120) includes a light transmissive base portion (121), and a plurality of structures (122) which are periodically arranged in a direction intersecting with the light transmissive substrate (110) to thereby form a diffraction grating (123) in the base portion (121).

## Description

### TECHNICAL FIELD

The present invention relates to a light emitting element and a method of manufacturing a light emitting element.

### BACKGROUND ART

There is a light emitting element including an organic light emitting layer in one light emitting element. In this light emitting element, it is desirable to improve a rate of light emitted to the outside, out of light generated in the organic light emitting layer (light extraction efficiency).

In Patent Documents 1 to 4, a technology is disclosed in which diffraction gratings (periodic structures) are arranged in parallel with a light transmissive substrate, and thus light extraction efficiency is improved. In addition, in Patent Document 5, a technology is disclosed in which light extraction efficiency is improved by using a diffraction grating.

### RELATED DOCUMENT

### PATENT DOCUMENT

[Patent Document 1] Japanese Unexamined Patent Application Publication No. 2009-272194
[Patent Document 2] Japanese Unexamined Patent Application Publication No. 2011-014361
[Patent Document 3] Japanese Unexamined Patent Application Publication No. 2012-014976
[Patent Document 4] Japanese Unexamined Patent Application Publication No. 2011-222421
[Patent Document 5] Japanese Unexamined Patent Application Publication No. 2008-269962

### SUMMARY OF THE INVENTION

An organic Electro Luminescence (EL) light emitting element, for example, is configured by laminating a light transmissive electrode, an organic functional layer including a light emitting layer, and a metal electrode on a light transmissive substrate such as a glass substrate.

In such a light emitting element, light in the direction of a normal line of the light transmissive substrate and light having an angle close to a direction of the normal line of the light transmissive substrate are easily extracted to the outside. However, light having a large angle with respect to the normal line of the light transmissive substrate is hard to be extracted to the outside for the reason that the light is totally reflected at a boundary surface between the light transmissive substrate and the light transmissive electrode due to a refractive index difference therebetween or the like.

An example of an object of the present invention is to improve light extraction efficiency of a light emitting element.

The invention according to Claim 1 is a light emitting element including a light transmissive substrate; a light emitting layer arranged on a side opposite to a light extraction side based on the light transmissive substrate; and a diffraction grating layer arranged on a side opposite to the light extraction side based on the light transmissive substrate, in which the diffraction grating layer includes a light transmissive base portion, and a plurality of structures which are periodically arranged in a direction intersecting with the light transmissive substrate to thereby form a diffraction grating in the base portion.

The invention according to Claim 10 is a method of manufacturing a light emitting element including a step of forming a light emitting layer on a side opposite to a light extraction side based on a light transmissive substrate; and a step of forming a diffraction grating layer on a side opposite to the light extraction side based on the light transmissive substrate, in which in the step of forming the diffraction grating layer, the diffraction grating layer is formed including a light transmissive base portion, and a plurality of structures are formed which are periodically arranged in a direction intersecting with the light transmissive substrate to thereby form a diffraction grating in the base portion.

### BRIEF DESCRIPTION OF THE DRAWINGS

The object described above, and other objects, characteristics, and advantages will become more obvious with reference to the following preferred embodiments and the following drawings attached thereto.

FIG. 1 (a) is a cross-sectional view of a light emitting element according to an embodiment, and FIG. 1(b) is an enlarged view of a main part of FIG. 1(a).
FIG. 2 is an enlarged view of a main part of FIG. 1(b).
FIG. 3 is a cross-sectional view illustrating a first example of a layer structure of an organic functional layer.
FIG. 4 is a cross-sectional view illustrating a second example of the layer structure of the organic functional layer.
FIG. 5 (a) is a cross-sectional view of a light emitting element according to Example 1, and FIG. 5(b) is an enlarged view of a main part of FIG. 5(a).
FIG. 6 is a perspective view of the light emitting element according to Example 1.
FIGS. 7(a) to 7(c) are diagrams illustrating a diffraction grating of a diffraction grating layer of the light emitting element according to Example 1, in which FIG. 7 (a) is a side cross-sectional view, FIG. 7(b) is a front view, and FIG. 7(c) is a plan view.
FIGS. 8(a) to 8(e) are diagrams for illustrating a method of manufacturing a light emitting element according to Example 1.
FIGS. 9(a) to 9(d) are diagrams illustrating a diffraction grating of a diffraction grating layer of the light emitting element according to Example 2, in which FIG. 9 (a) is a side cross-sectional view, FIG. 9(b) is a front view, FIG. 9(c) is a plan view, and FIG. 9(d) is a diagram illustrating a part of FIG. 9(b).
FIG. 10 is a cross-sectional view of a main part of a light emitting element according to Example 3.
FIG. 11(a) is a cross-sectional view of a main part of a light emitting element according to Example 4, and FIG. 11 (b) is an enlarged view of a main part of FIG. 11(a).
FIGS. 12(a) to 12(c) are diagrams illustrating a first example of a diffraction grating of a diffraction grating layer of the light emitting element according to Example 4, in which FIG. 12(a) is a side cross-sectional view, FIG. 12 (b) is a front view, and FIG. 12 (c) is a plan view. FIGS. 12(d) to 12(f) are diagrams illustrating a second example of the diffraction grating of the diffraction grating layer of the light emitting element according to Example 4, in which FIG. 12 (d) is a side cross-sectional view, FIG. 12 (e) is a front view, and FIG. 12(f) is a plan view.
FIGS. 13(a) to 13(c) are diagrams for illustrating a method of manufacturing a light emitting element according to Example 4.
FIG. 14 (a) is a plan view of a light emitting element according to Example 5, and FIG. 14(b) is a cross-sectional view taken along line B-B of FIG. 14(a).
FIG. 15(a) is a cross-sectional view of a main part of a light emitting element according to Example 6, and FIG. 15 (b) is an enlarged view of a main part of FIG. 15(a).
FIGS. 16(a) to 16(e) are diagrams for illustrating a method of manufacturing a light emitting element according to Example 6.
FIG. 17 is a cross-sectional view of a light emitting element according to Example 7.
FIG. 18 is a plan view of a light emitting element according to Example 8.

### DESCRIPTION OF EMBODIMENTS

Hereinafter, embodiments of the present invention will be described with reference to the drawings. Furthermore, in all of the drawings, the same reference numerals are applied to the same constituent parts, and the descriptions thereof will not be repeated.

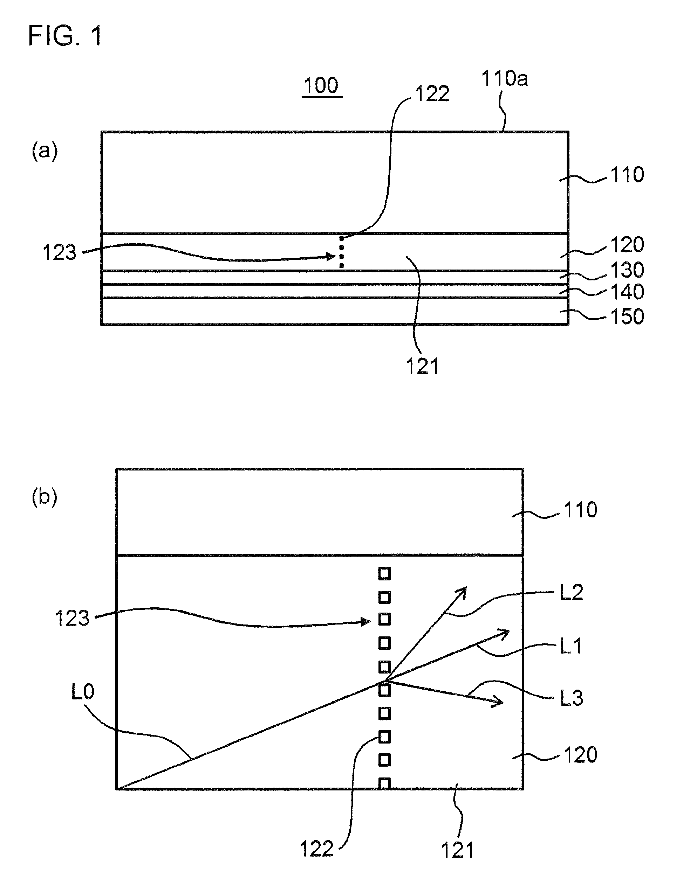

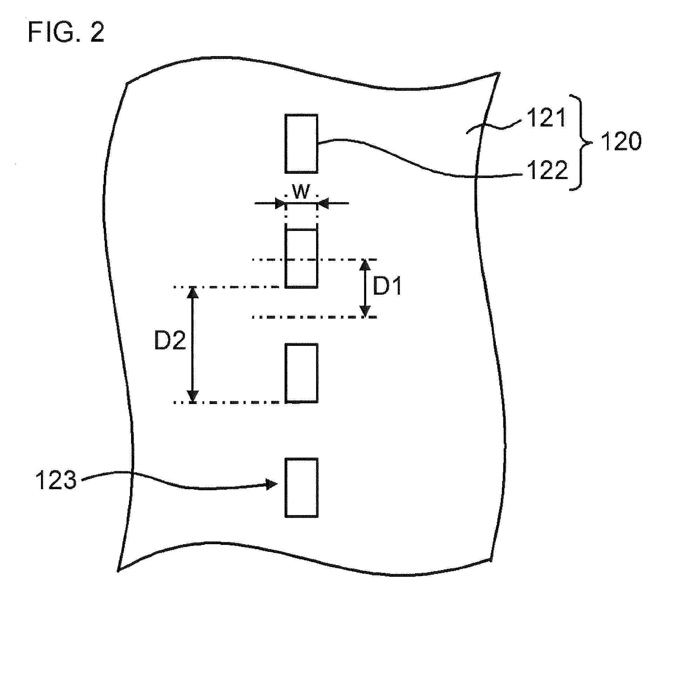

FIG. 1 (a) is a cross-sectional view of a light emitting element 100 according to an embodiment, and FIG. 1(b) is an enlarged view of a main part of FIG. 1(a). FIG. 2 is an enlarged view of a main part of FIG. 1(b). The light emitting element 100 is configured by including an organic Electro Luminescence (EL) element. The light emitting element 100, for example, is able to be used as a light source of a display, an illuminating device, or an optical communication device.

The light emitting element 100 according to this embodiment includes a light transmissive substrate 110, a light emitting layer arranged on a side opposite to a light extraction side based on the light transmissive substrate 110, and a diffraction grating layer 120 arranged on a side opposite to the light extraction side based on the light transmissive substrate 110. The diffraction grating layer 120 includes a light transmissive base portion 121, and a plurality of structures 122 which are periodically arranged in a direction intersecting with the light transmissive substrate 110 to thereby form a diffraction grating 123 in the base portion 121. Here, "intersecting with the light transmissive substrate 110" indicates intersecting with a surface (a lower surface in FIG. 1(a)) of the light transmissive substrate 110 on the light emitting layer side, intersecting with a surface (an upper surface in FIG. 1(a)) of the light transmissive substrate 110 on a side opposite to the light emitting layer side, or intersecting with a surface to which the light transmissive substrate 110 extends. In addition, "light extraction side" indicates a light extraction surface side (for example, a light extraction surface 110a side) described later.

As described later, for the sake of simple description, a positional relationship (an up and down relationship or the like) of each constituent of the light emitting element 100 will be described by using a relationship illustrated in each drawing. However, the positional relationship in the description has no connection to a positional relationship at the time of using the light emitting element 100 or at the time of manufacturing the light emitting element 100.

In this embodiment, as illustrated in FIG. 1(a), the light emitting element 100 includes the light transmissive substrate 110, the diffraction grating layer 120, a first electrode 130, an organic functional layer 140, and a second electrode 150 in this order from an upper side. In addition, the organic functional layer 140 is configured by including at least the light emitting layer. For this reason, the diffraction grating layer 120 is arranged between the light transmissive substrate 110 and the light emitting layer.

The light transmissive substrate 110 is a plate-like member formed of a material having light transmissivity such as glass or a resin. For example, an upper surface of the light transmissive substrate 110, that is, a surface of the light transmissive substrate 110 on a side opposite to the organic functional layer 140 is the flat light extraction surface 110a. The light extraction surface 110a is in contact with air (refractive index 1) filling a light emission space. Furthermore, a light extraction film may be attached to the upper surface of the light transmissive substrate 110, and the light extraction surface may be configured of an upper surface of the light extraction film.

As described above, the diffraction grating layer 120 includes the diffraction grating 123. As described later in detail, light passes through the diffraction grating 123, and thus the light is divided into zero-order light and higher-order light. Then, a part of the light is directed toward an upper side, that is, towards a direction of being extracted to the outside of the light emitting element 100 (the direction of first-order light L2 in FIG. 1(b), or the like), and thus light extraction efficiency of the light emitting element 100 is improved.

The base portion 121, for example, is configured of a dielectric body or the like. A refractive index of the base portion 121, for example, is greater than a refractive index of the light transmissive substrate 110 and less than or equal to 2.3. A material of the base portion 121, for example, may be identical to a material of the organic functional layer 140. A refractive index of the organic functional layer 140, for example, is approximately greater than or equal to 1. 6 and less than or equal to 2.0. In addition, the refractive index of the base portion 121, for example, is greater than or equal to a refractive index of the first electrode 130.

The structure 122 of the diffraction grating layer 120, for example, is a hollow region formed in the base portion 121. However, the structure 122 may be configured of metal. In addition, the structure 122 may be configured of a light transmissive material having a refractive index different from that of the base portion 121. In this case, the structure 122 is able to be formed by irradiating a part of the base portion 121 with a light ray, by metamorphosing the part with heat, and by changing the refractive index thereof.

The first electrode 130, for example, may be a transparent electrode formed of a metal oxide conductor of Indium Tin Oxide (ITO), Indium Zinc Oxide (IZO), and the like. However, the first electrode 130 may be a thin metal film which is thin to the extent of transmitting the light.

The second electrode 150, for example, is a reflective electrode formed of a metal film of Ag, Au, Al, and the like. The second electrode 150 reflects the light which is directed from the organic functional layer 140 towards the second electrode 150 side, towards the light extraction surface 110a side. That is, the second electrode 150 also functions as a light reflective layer.

However, the second electrode 150 may be formed of a transparent electrode formed of a metal oxide conductor of ITO, IZO, and the like, or the second electrode 150 may be formed of a thin metal film which is thin to the extent of transmitting the light, and a light reflective layer (not illustrated) may be disposed under the second electrode 150.

For example, the first electrode 130 configures a anode, and the second electrode 150 configures a cathode. By applying a voltage between the first electrode 130 and the second electrode 150, the light emitting layer of the organic functional layer 140 emits light. All of the light transmissive substrate 110, the diffraction grating layer 120, the first electrode 130, the organic functional layer 140, and the second electrode 150 transmit at least a part of the light emitted by the light emitting layer of the organic functional layer 140. A part of the light emitted by the light emitting layer is emitted (extracted) from the light extraction surface 110a of the light transmissive substrate 110 to the outside of the light emitting element 100 (that is, the light emission space).

In the diffraction grating layer 120, the entire region other than the structure 122 may be the base portion 121, and the diffraction grating layer 120 may be configured of a region other than the structure 122 and the base portion 121.

In the diffraction grating layer 120, the plurality of structures 122 are periodically (repeatedly) arranged in a direction intersecting with the light transmissive substrate 110. More specifically, for example, the plurality of structures 122 are arranged at constant intervals in the direction intersecting with the light transmissive substrate 110. However, an interval between the adjacent structures 122 may not be constant. As illustrated in FIG. 1, the direction in which the plurality of structures 122 are arranged, for example, is a direction orthogonal to the light transmissive substrate 110. However, the direction in which the plurality of structures 122 are arranged may be the other direction insofar as the direction is a direction intersecting with the light transmissive substrate 110.

For example, one surface of the light transmissive substrate 110 (the lower surface in FIG. 1 (a)) and one surface of the diffraction grating layer 120 (an upper surface in FIG. 1(a)) are in contact with each other. In addition, the other surface of the diffraction grating layer 120 (a lower surface in FIG. 1(a)) and one surface of the first electrode 130 (an upper surface in FIG. 1(a)) are in contact with each other. In addition, the other surface of the first electrode 130 (a lower surface in FIG. 1(a)) and one surface of the organic functional layer 140 (an upper surface in FIG. 1(a)) are in contact with each other. In addition, the other surface of the organic functional layer 140 (a lower surface in FIG. 1(a)) and one surface of the second electrode 150 (an upper surface in FIG. 1(a)) are in contact with each other. However, another layer may be disposed between the light transmissive substrate 110 and the diffraction grating layer 120. Similarly, another layer may be disposed between the diffraction grating layer 120 and the first electrode 130. Similarly, another layer may be disposed between the first electrode 130 and the organic functional layer 140. Similarly, another layer may be disposed between the organic functional layer 140 and the second electrode 150.

Next, an example of a layer structure of the organic functional layer 140 will be described.

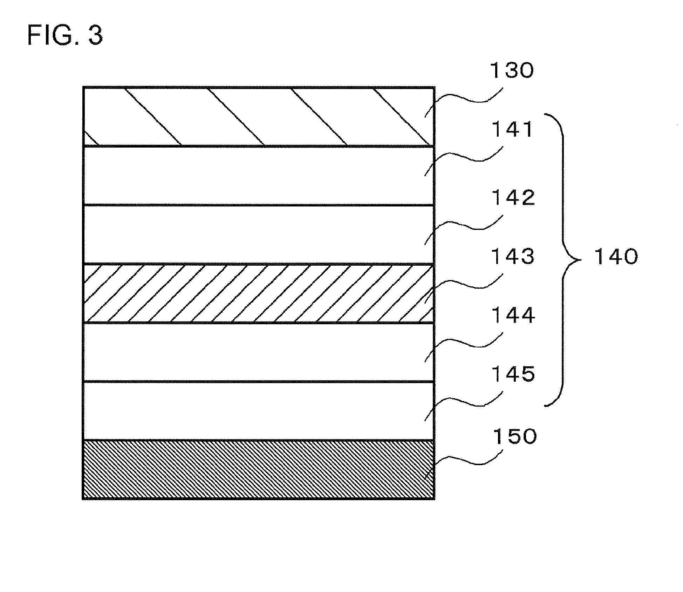

FIG. 3 is a cross-sectional view illustrating a first example of the layer structure of the organic functional layer 140. The organic functional layer 140 according to the first example has a structure in which a hole injection layer 141, a hole transport layer 142, a light emitting layer 143, an electron transport layer 144, and an electron injection layer 145 are laminated in this order. That is, the organic functional layer 140 is an organic electroluminescence light emitting layer. Furthermore, instead of the hole injection layer 141 and the hole transport layer 142, one layer which functions as these two layers may be disposed. Similarly, instead of the electron transport layer 144 and the electron injection layer 145, one layer which functions as these two layers may be disposed.

In the first example of the organic functional layer 140, the light emitting layer 143, for example, is a layer emitting red light, a layer emitting blue light, or a layer emitting green light. In this case, in a plan view, a region including the light emitting layer 143 which emits red light, a region including the light emitting layer 143 which emits green light, and a region including the light emitting layer 143 which emits blue light may be repeatedly disposed. In this case, when the respective regions simultaneously emit light, the light emitting element 100 emits light having a single color such as a white color.

Furthermore, the light emitting layer 143 may be configured to emit light having a single color such as a white color by mixing materials for emitting light having a plurality of colors.

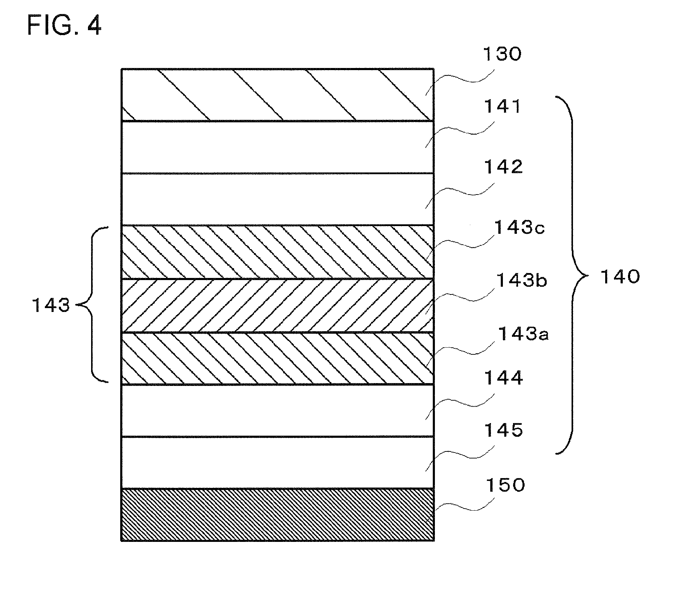

FIG. 4 is a cross-sectional view illustrating a second example of the layer structure of the organic functional layer 140. In this example, the light emitting layer 143 of the organic functional layer 140 has a configuration in which light emitting layers 143a, 143b, and 143c are laminated in this order. The light emitting layers 143a, 143b, and 143c emit light having colors different from each other (for example, red, green, and blue). By the light emitting layers 143a, 143b, and 143c simultaneously emitting light, the light emitting element 100 emits light having a single color such as a white color.

Next, the operation will be described.

In FIG. 1(a), the light emitted from a light emitting point of the light emitting layer 143 of the organic functional layer 140 (refer to FIG. 3 and FIG. 4) passes through the hole transport layer 142 and the hole injection layer 141 of the organic functional layer 140 (refer to FIG. 3 and FIG. 4), further passes through the first electrode 130, and then is incident on the base portion 121 having a refractive index of approximately greater than or equal to that of the first electrode 130.

The light incident on the diffraction grating layer 120 is diffracted by passing through the diffraction grating 123 configured of the plurality of structures 122, and thus is divided into zero-order light and plus or minus higher-order light. In FIG. 1(b), an aspect is illustrated in which light L0 incident on the diffraction grating layer 120 is divided into zero-order light L1, first-order light L2, and minus first-order light L3 by passing through the diffraction grating 123.

Here, as an example, a case is considered in which the refractive index of the base portion 121 is 1.8, and the light emitted from the light emitting layer 143 is green light having a peak wavelength of 560 nm. In this case, a peak wavelength of the light in the base portion 121 is 560 nm/1.8, that is, approximately 310 nm.

An interval D1 illustrated in FIG. 2 is an interval (an interval in the direction in which the plurality of structures 122 are arranged) between light which proceeds in the direction orthogonal to the diffraction grating 123 (a right and left direction in FIG. 2) and passes through the center of the structure 122, and light which proceeds in the direction orthogonal to the diffraction grating 123 (the right and left direction in FIG. 2) and passes through the center of the interval between the adjacent structures 122. A diffraction angle increases as the interval D1 becomes closer to the wavelength. The interval D1, for example, is set to be greater than 310 nm which is a peak wavelength of the base portion 121 (for example, the interval D1 is 400 nm).

In addition, an interval D2 between the adjacent structures 122 is twice the interval D1. For this reason, the interval D2, for example, is 800 nm.

In addition, an intensity ratio of the zero-order light and the higher-order light (in particular, plus or minus first-order light) is determined by the depth of the diffraction grating 123 (a distance through which the light passes), and the depth of the structure 122 (a width W in FIG. 2).

In order to decrease the intensity ratio of the zero-order light, it is preferable that the depth of the structure 122 (the width W) is set to be λ/2. For this reason, the width W, for example, is set to be 160 nm which is approximately 1/2 of 310 nm.

When the diffraction grating 123 which is set in this way is used, the intensity of the ±first-order light (the first-order light L2 and the minus first-order light L3 in FIG. 1(b)) is able to be designed to be maximized.

Here, when the diffraction grating layer 120 is not disposed, the light L0 is light which is totally reflected on a boundary surface between the first electrode 130 and the light transmissive substrate 110 downwardly, that is, light of greater than or equal to a critical angle in the boundary surface between the first electrode 130 and the light transmissive substrate 110. That is, when the diffraction grating layer 120 is not disposed, the light L0 is light which is attenuated by a reflection ratio of a reflective cathode (the second electrode 150) or an attenuation coefficient of the organic functional layer 140 as the light is repeatedly reflected between the light transmissive substrate 110 and the second electrode 150.

In this case, as illustrated in FIG. 1(b), the angle of the first-order light L2 is directed further upward than the angle of the zero-order light, and thus it can be expected that the first-order light L2 is able to be incident on the light transmissive substrate 110 from the diffraction grating layer 120 and is further able to be emitted to the light emission space from the light transmissive substrate 110.

That is, it is determined whether the first-order light L2 is incident on the light transmissive substrate 110 or is totally reflected on the boundary surface between the diffraction grating layer 120 and the light transmissive substrate 110, according to the angle. Similarly, it is determined whether the first-order light L2 incident on the light transmissive substrate 110 is emitted to the light emission space from the light transmissive substrate 110 or is totally reflected on the boundary surface between the light transmissive substrate 110 and the light emission space, according to the angle thereof.

Therefore, for the light L0 having angle conditions in which the first-order light L2 incident on the light transmissive substrate 110 is emitted to the light emission space from the light transmissive substrate 110, a part thereof is extracted to the light emission space.

In addition, even though it is not illustrated, the higher-order light of higher than or equal to second-order light is diffracted at an angle greater than that of the first-order light, and thus a large ratio of light of the higher-order light is emitted to the emission space.

Thus, when the diffraction grating layer 120 is not disposed, a part of the light L0, having an angle with which the light is not emitted to the emission space, is able to be emitted to the emission space by the operation of the diffraction grating layer 120.

In addition, regarding the light having an angle with which the light is emitted to the light emission space even when the diffraction grating layer 120 is not disposed, most of the light is transmitted through the diffraction grating layer 120 and the light transmissive substrate 110 and is emitted to the light emission space without being incident on the diffraction grating 123. In addition, among the light having an angle with which the light is emitted to the light emission space even when the diffraction grating layer 120 is not disposed, a part of the light incident on the diffraction grating 123 is also emitted to the light emission space.

Accordingly, light extraction efficiency of the light emitting element 100 is improved, compared to a case where the diffraction grating layer 120 is not disposed.

Further, the light emitting element 100 according to this embodiment has a structure in which light perpendicular to the light extraction surface 110a is rarely affected. In other words, the light emitting element 100 according to this embodiment has a structure of strongly affecting light which repeats reflection, and thus it is possible to expect improvement in light extraction efficiency.

Next, an example of a method of manufacturing a light emitting element according to this embodiment will be described. The method of manufacturing includes the following steps of (1) and (2).
(1) A step of forming the light emitting layer on the side opposite to the light extraction side based on the light transmissive substrate 110.
(2) A step of forming the diffraction grating layer 120 on the side opposite to the light extraction side based on the light transmissive substrate 110.

In the step of forming the diffraction grating layer 120, the diffraction grating layer 120 is formed including the light transmissive base portion 121, and the plurality of structures 122 are formed which are periodically arranged in the direction intersecting with the light transmissive substrate 110 to thereby form the diffraction grating in the base portion 121.

First, the diffraction grating layer 120 is formed on the lower surface of the light transmissive substrate 110. The structure 122 of the diffraction grating layer 120 may be formed in the shape of a hollow, may be formed of metal, or may be formed by changing a refractive index of a part of the region of the base portion 121. A specific example of a method of forming the diffraction grating layer 120 will be described with reference to examples described later.

Next, a light transmissive conductive film formed of a metal oxide conductor of ITO, IZO, and the like is formed on the lower surface of the diffraction grating layer 120 by a sputtering method or the like, and the light transmissive conductive film is patterned by etching, and thus the first electrode 130 is formed.

Next, an organic material is applied onto the lower surface of the first electrode 130, and thus the organic functional layer 140 is formed.

Next, a metal material such as Ag, Au, and Al is deposited on the lower surface of the organic functional layer 140 by a vapor deposition method or the like, and thus the second electrode 150 is formed.

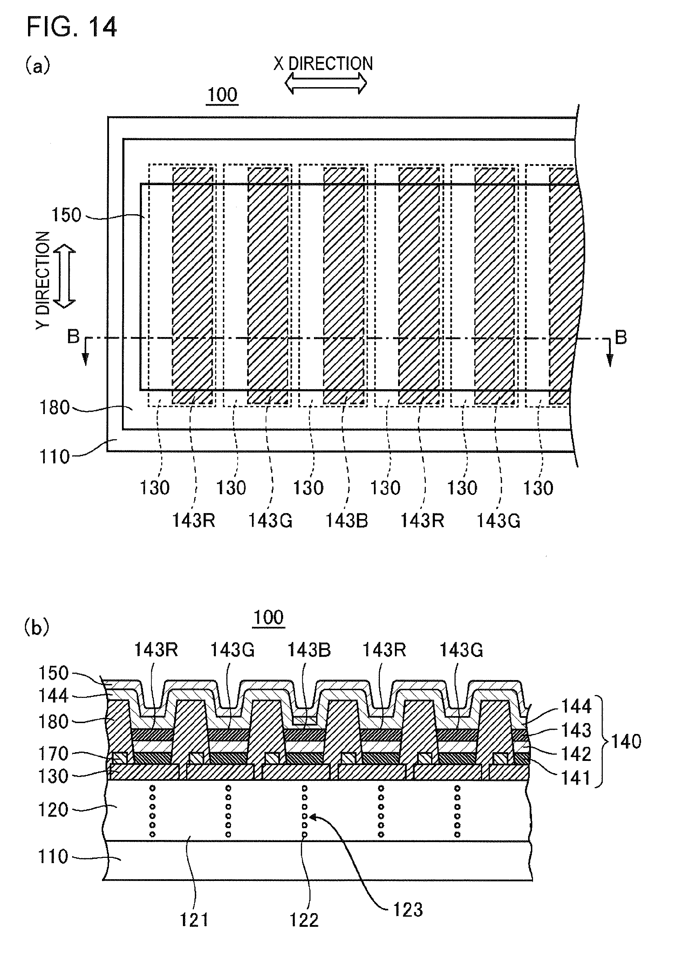

Furthermore, as necessary, each of a bus line 170 and a partition wall portion 180 (refer to FIG. 14) may be formed at a suitable timing. In addition, as necessary, a sealing layer may be formed on a lower surface of the second electrode 150.

As described above, according to the embodiment, the light emitting element 100 includes the light transmissive substrate 110, and the light emitting layer and the diffraction grating layer 120 which are arranged on the side opposite to the light extraction side based on the light transmissive substrate 110. The diffraction grating layer 120 includes the base portion 121, and the plurality of structures 122 which are periodically arranged in the direction intersecting with the light transmissive substrate 110 to thereby form the diffraction grating 123 in the base portion 121. Accordingly, a part of the light which is not emitted to the emission space when the diffraction grating layer 120 is not disposed is able to be emitted to the emission space by changing the angle thereof to an angle at which the light is emitted to the emission space according to the operation of the diffraction grating 123. Accordingly, light extraction efficiency of the light emitting element 100 is improved, compared to a case where the diffraction grating layer 120 is not disposed.

In addition, when the refractive index of the base portion 121 is greater than the refractive index of the light transmissive substrate 110 and less than or equal to 2.3, the light from the light emitting layer to the base portion 121 is able to be smoothly made incident thereon, and the light from the base portion 121 to the light transmissive substrate 110 is able to be easily made incident thereon.

In addition, the diffraction grating layer 120 is arranged between the light transmissive substrate 110 and the light emitting layer, and thus a part of the light which is directed from the light emitting layer towards the light transmissive substrate 110 side is able to be extracted to the outside from the light emitting element 100 by changing the direction of the part of the light by using the diffraction grating 123.

### [Examples]

### (Example 1)

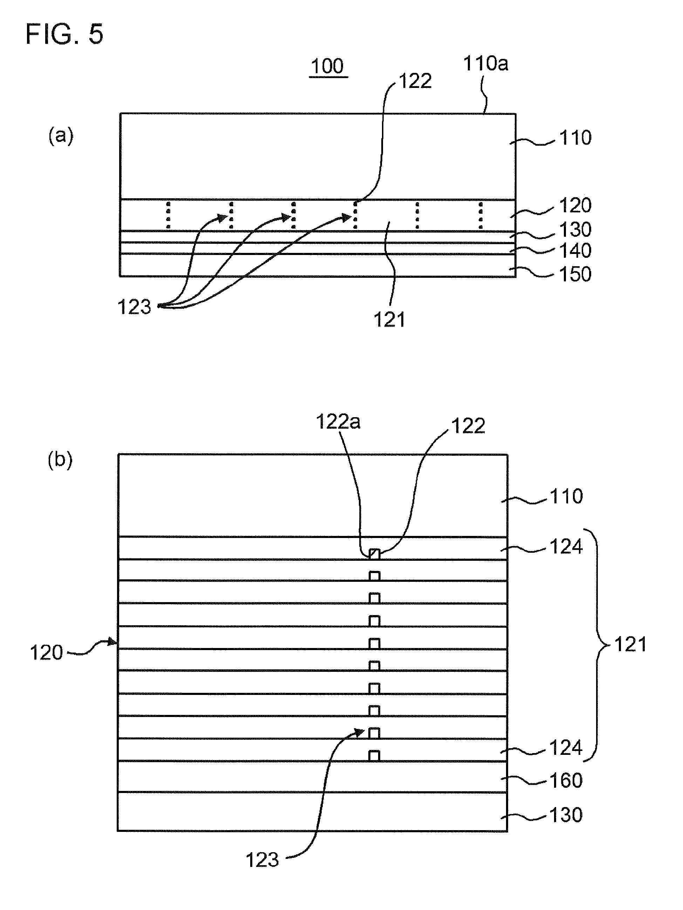

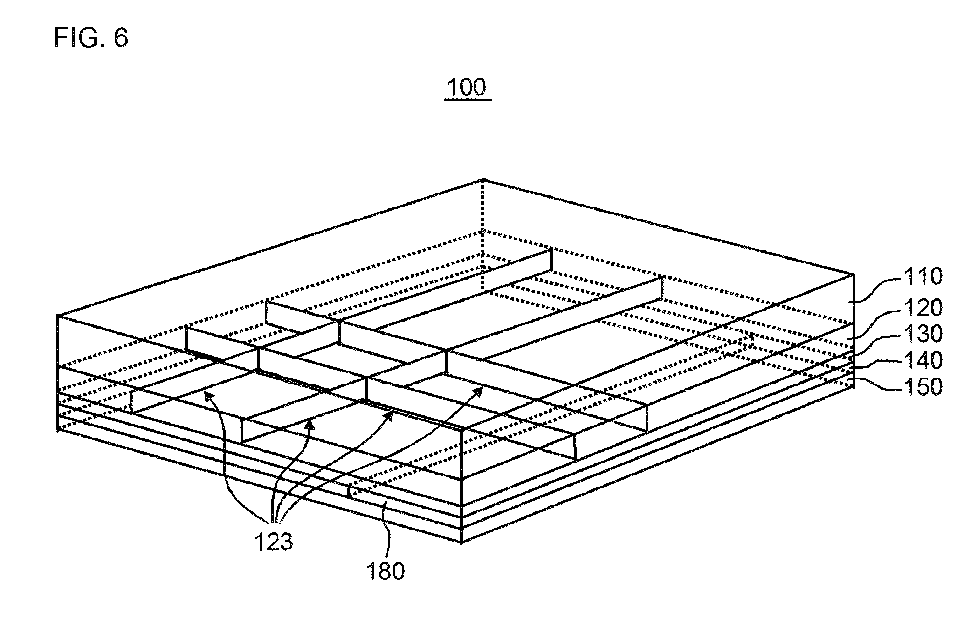

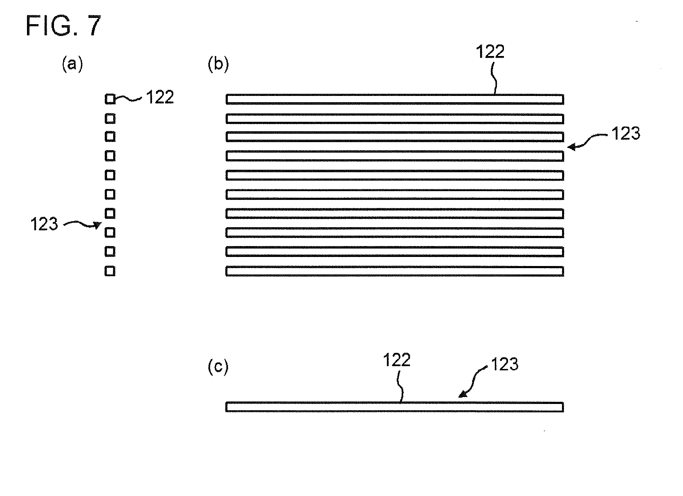

FIG. 5 (a) is a cross-sectional view of the light emitting element 100 according to Example 1, and FIG. 5(b) is an enlarged view of a main part of FIG. 5(a). FIG. 6 is a perspective view of the light emitting element 100 according to Example 1. FIGS. 7(a) to 7(c) are diagrams illustrating the diffraction grating of the diffraction grating layer 120 of the light emitting element 100 according to Example 1, in which FIG. 7(a) is a side cross-sectional view, FIG. 7 (b) is a front view, and FIG. 7 (c) is a plan view. The light emitting element 100 according to this example is different from the light emitting element 100 according to the embodiment described above in the following points, and the other configuration is identical to that of the light emitting element 100 according to the embodiment described above.

As illustrated in FIG. 5(a), a plurality of diffraction gratings 123 are formed in the diffraction grating layer 120. These diffraction gratings 123 are arranged by being separated from each other in a plan view.

As illustrated in FIG. 6, each of the diffraction gratings 123 is formed in the shape of a wall intersecting with (for example, orthogonal to) the light transmissive substrate 110. In FIG. 6, an example is illustrated in which four wall-like diffraction gratings 123 are arranged in the shape of a grating in a plan view, and more diffraction gratings 123 may be arranged in the diffraction grating layer 120. When the plurality of wall-like diffraction gratings 123 is arranged in the shape of a grating in a plan view, the diffraction gratings 123 which are parallel with each other, and diffraction gratings 123 which are orthogonal to each other are included.

In addition, the diffraction gratings 123 which are orthogonal to each other in a plan view may not directly intersect with each other by arranging the diffraction gratings 123 to be shifted from each other in an up and down direction.

As illustrated in FIG. 5(a), an example is preferable in which the plurality of wall-like diffraction gratings 123 are periodically (for example, at constant intervals) arranged in parallel with each other. The direction of arrangement of the plurality of wall-like diffraction gratings 123, for example, is a direction parallel with the light transmissive substrate 110, as illustrated in FIG. 5(a). Furthermore, the direction of arrangement of the plurality of structures 122 configuring each of the diffraction gratings 123 is a direction intersecting with (for example, orthogonal to) the light transmissive substrate 110, similar to the embodiment described above.

In this example, each of the structures 122 is a hollow structure formed in the base portion 121. For this reason, each of the structures 122 has a refractive index different from that of the base portion 121. More specifically, for example, the base portion 121 is configured by laminating a plurality of light transmissive films 124. A concave portion 122a configuring the structure 122 is formed in each of the light transmissive films 124. The hollow region in the concave portion 122a configures the structure 122.

As illustrated in FIGS. 7(a) to 7(c), in particular, as illustrated in FIG. 7(b), each of the plurality of structures 122 forming one diffraction grating 123 extends in parallel with the light transmissive substrate 110, the structures being arranged in parallel with each other. The wall-like diffraction grating 123 is formed of the plurality of structures 122.

In this example, the base portion 121 is configured by laminating a multi-layer light transmissive film 124, and thus flatness of a lower surface of the base portion 121 (a surface on the first electrode 130 side) may not be sufficiently ensured. For this reason, a barrier film 160 (FIG. 5(b)) is formed between the base portion 121 and the first electrode 130. It is preferable that a lower surface of the barrier film 160 is formed to be flatter than the lower surface of the base portion 121. The barrier film 160, for example, is formed of a SiO₂ thin film, graphene, or the like. The barrier film 160 has a function of suppressing an influence to an organic material.

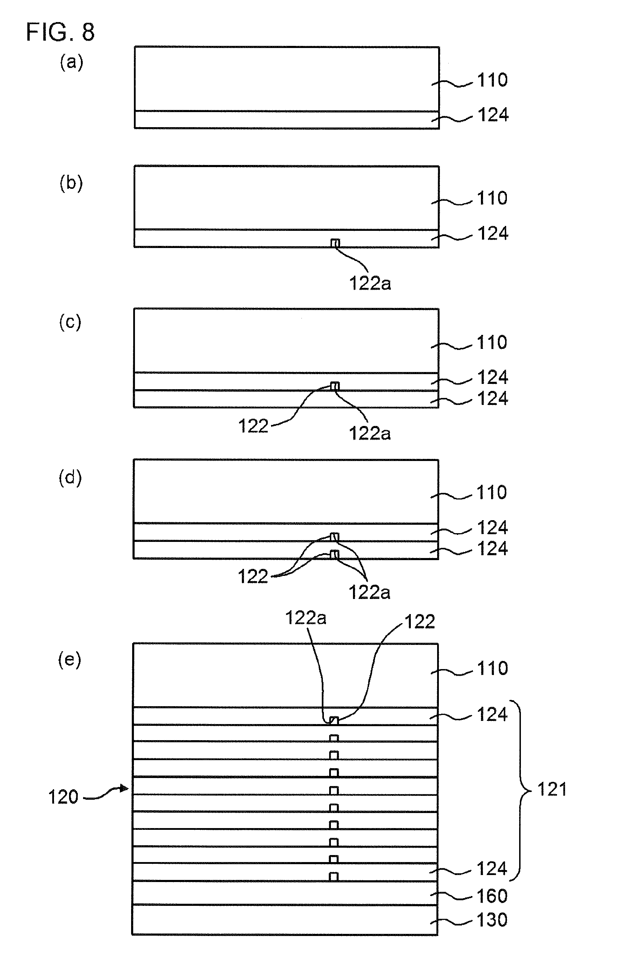

Next, in the method of manufacturing the light emitting element 100 according to this example, the step of forming the diffraction grating layer 120 will be mainly described. FIGS. 8(a) to 8(e) are diagrams for illustrating a method of manufacturing the light emitting element 100 according to Example 1.

In this example, in the step of forming the diffraction grating layer 120, a step of forming the light transmissive film 124 configuring a part of the base portion 121 and a step of forming the concave portion 122a configuring the structure 122 by performing imprinting with respect to the light transmissive film 124 are alternately repeated. Accordingly, the base portion 121 is formed by a plurality of layers of the light transmissive film 124 respectively including the structure 122 therein.

First, as illustrated in FIG. 8(a), a first layer of the light transmissive film 124 is attached onto the lower surface of the light transmissive substrate 110. Furthermore, a material of the light transmissive film 124, for example, has a high refractive index by using an organic material such as polyethylene terephthalate (PET) or polyethylene naphthalate (PEN) as a base, and by mixing a nanocomposite or nanoparticle material using TiBO₂ into the organic material. A refractive index of the light transmissive film 124, for example, may be approximately 1.8. A film thickness of the light transmissive film 124, for example, may be approximately 800 nm. Here, in order to easily perform the imprinting, the light transmissive film 124 is attached onto the light transmissive substrate 110 in a state where the light transmissive film 124 is heated.

Next, as illustrated in FIG. 8(b), the imprinting is performed with respect to a lower surface of the first layer of the light transmissive film 124, and thus the concave portion 122a is formed in the lower surface of the light transmissive film 124. A depth of the concave portion 122a may be approximately 400 nm. The imprinting is performed by pressing a metal mold to the light transmissive film 124. After performing the imprinting, the light transmissive film 124 is cooled.

Next, as illustrated in FIG. 8 (c), the second layer of the light transmissive film 124 is attached onto the lower surface of the first layer of the light transmissive film 124 in a state where the second layer of the light transmissive film 124 is heated. Next, as illustrated in FIG. 8(d), the imprinting is performed with respect to a lower surface of the second layer of the light transmissive film 124, and thus the concave portion 122a is formed in the lower surface of the light transmissive film 124. Here, the concave portion 122a of the second layer of the light transmissive film 124 is formed in a position which overlaps with the concave portion 122a of the first layer of the light transmissive film 124 in a plan view. After that, the light transmissive film 124 is cooled.

Hereinafter, similarly, a step of attaching the light transmissive film 124, and a step of forming the concave portion 122a in the newly attached light transmissive film 124 by performing the imprinting with respect to a lower surface thereof are alternately repeated. Accordingly, as illustrated in FIG. 8(e), the base portion 121 is formed configured of the multiple layers (for example, 10 layers) of the light transmissive films 124 each including therein the structure 122 formed of the concave portion 122a. Further, the barrier film 160 and the first electrode 130 are sequentially formed on the lower surface of the base portion 121. The other step is identical to that in the embodiment described above, and thus the description will not be repeated.

Next, the operation will be described.

In this example, the operation of each of the diffraction gratings 123 is identical to that in the embodiment described above. However, in this example, the plurality of diffraction gratings 123 is formed in the diffraction grating layer 120, and thus a part of the zero-order light L1, the minus first-order light L3, and light of lower than or equal to minus second-order (minus second-order light, minus third-order light, and the like) which are generated in one diffraction grating 123 is able to be extracted to the light emission space.

The angle of the zero-order light L1 is an angle identical to that of the light L0 (refer to FIG. 1(b)) before diffraction occurs. The zero-order light L1, for example, is totally reflected on the boundary surface between the diffraction grating layer 120 and the light transmissive substrate 110, and then is totally reflected on the second electrode 150, and is incident on the other diffraction grating 123. As a result thereof, a part of the zero-order light L1 is extracted to the light emission space by the same mechanism described in the embodiment described above.

In addition, the minus first-order light L3 is directed upward or downward according to the angle of the light L0.

The minus first-order light L3 which is directed upward, for example, is totally reflected on the boundary surface between the diffraction grating layer 120 and the light transmissive substrate 110, and then is totally reflected on the second electrode 150, and is incident on the other diffraction grating 123. As a result thereof, a part of the minus first-order light L3 is extracted to the light emission space by the same mechanism described in the embodiment described above.

In addition, the minus first-order light L3 which is directed downward is totally reflected on the second electrode 150, and is incident on the other diffraction grating 123. As a result thereof, a part of the minus first-order light L3 is extracted to the light emission space by the same mechanism described in the embodiment described above.

In addition, a part of the light of less than or equal to minus second-order (the minus second-order light, the third-order light, and the like) is able to be extracted to the light emission space by the same mechanism as that of the minus first-order light L3.

For this reason, in this example, light extraction efficiency is further improved compared to the embodiment described above.

According to this example, the diffraction grating layer 120 includes the plurality of diffraction gratings 123 which are arranged by being separated from each other in a plan view. Accordingly, even for the light which cannot be extracted to the light emission space by the operation of only one diffraction grating 123, a part thereof is also able to be extracted to the light emission space by another diffraction grating 123. Accordingly, it is possible to further increase light extraction efficiency compared to the embodiment described above.

Furthermore, as illustrated in FIG. 6, by arranging the plurality of wall-like diffraction gratings 123 in the shape of a grating in a plan view, a probability that light having various directions in a plan view is incident on any of the diffraction gratings 123 increases. As a result thereof, it is possible to further increase light extraction efficiency compared to the embodiment described above.

In addition, the structure 122 has a refractive index different from that of the base portion 121, and thus it is possible to diffract the light transmitting through the diffraction grating 123 by using a refractive index difference between the structure 122 and the base portion 121.

In addition, each of the plurality of structures 122 forming one diffraction grating 123 extends in parallel with the light transmissive substrate 110, and is arranged in parallel with each other. For this reason, the wall-like diffraction grating 123 is formed by the plurality of structures 122. In this case, light having a direction intersecting with a wall surface formed by the diffraction grating 123 is incident on the diffraction grating 123, and thus a part of the light is able to be extracted to the light emission space by diffracting the light.

In addition, in the step of forming the diffraction grating layer 120, the step of forming the light transmissive film 124 configuring a part of the base portion 121 and the step of forming the concave portion 122a configuring the structure 122 by performing the imprinting with respect to the light transmissive film 124 are alternately repeated, and thus the base portion 121 is formed by the plurality of layers of the light transmissive film 124 respectively including the structure 122 therein. Accordingly, the structure 122 is easily formed at a desired interval and in a desired shape, and thus it is possible to easily form the diffraction grating 123 having a desired structure.

Furthermore, in Example 1 described above, an example is described in which the step of attaching the light transmissive film 124 which is formed in advance and the step of forming the concave portion 122a in the light transmissive film 124 are alternately performed, and the light transmissive film 124 may be formed by applying and curing an organic liquid material. In addition, the concave portion 122a may be formed in the light transmissive film 124 in advance, and then the light transmissive film 124 may be sequentially attached.

### (Example 2)

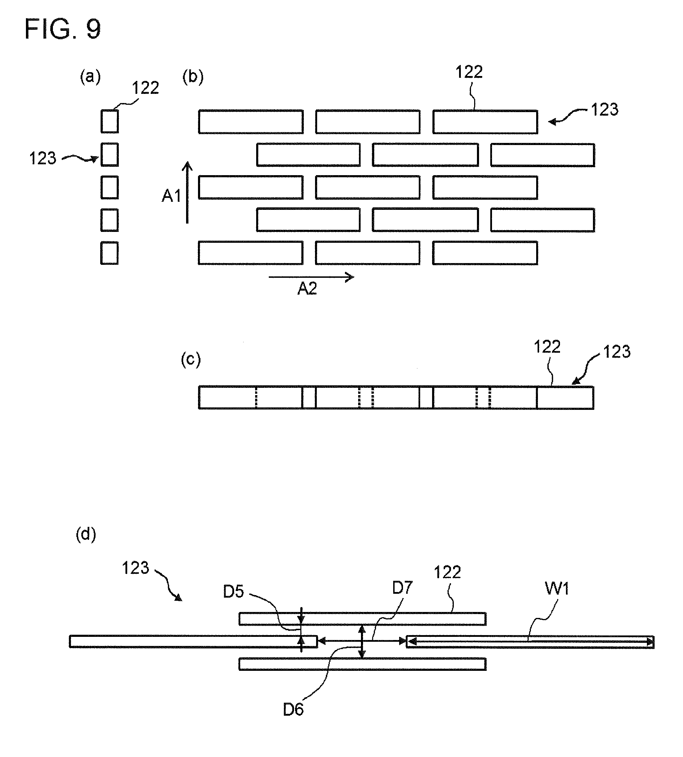

FIGS. 9(a) to 9(d) are diagrams illustrating the diffraction grating 123 of the diffraction grating layer 120 (refer to FIG. 5(a)) of a light emitting element according to Example 2, in which FIG. 9 (a) is a side cross-sectional view, FIG. 9 (b) is a front view, FIG. 9(c) is a plan view, and FIG. 9(d) is a diagram illustrating a part of FIG. 9(b). The light emitting element according to this example is different from the light emitting element 100 according to Example 1 described above in the structure of the diffraction grating 123, and the other configuration is identical to that of the light emitting element 100 according to Example 1 described above.

In this example, in a plane intersecting with the light transmissive substrate 110, the plurality of structures 122 forming one diffraction grating 123 are periodically arranged in a first direction intersecting with the light transmissive substrate 110 (for example, a direction orthogonal to the light transmissive substrate 110 (not illustrated in FIG. 9(b)) such as a direction of an arrow A1 in FIG. 9(b)), and are arranged by being distributed in a second direction intersecting with the first direction (for example, a direction orthogonal to the arrow A1 such as a direction of an arrow A2 in FIG. 9 (b)). Then, when the one diffraction grating 123 is viewed from the first direction, the plurality of structures 122 is arranged such that an interval between the structures 122 in a row of the plurality of structures 122 which are arranged in the second direction is occupied by the structure 122 in the adjacent row (refer to FIG. 9 (c)). Accordingly, an interval between the structures 122 in a row of the plurality of structures 122 which are arranged in the second direction abuts on the structure 122 in the adjacent row. More specifically, as illustrated in FIG. 9(b), the interval between the structures 122 is formed in the shape of a T-intersection. Furthermore, periodicity and a dimension of the plurality of structures 122 in the direction of an arrow A1 are identical to those in the embodiment described above. In addition, as illustrated in FIG. 9(d), it is preferable that a dimension (a length) W1 of the structure 122 in the second direction is greater than an interval D7 between the structures 122 in the row of the plurality of structures 122 which are arranged in parallel in the second direction. For example, it is preferable that the length W1 of the structure 122 in the second direction is greater than or equal to 10 times the interval D7 between the structures 122 arranged in the second direction. In addition, it is preferable that the interval D7 between the structures 122 arranged in the second direction is wider than an interval D6. For example, it is preferable that the interval D7 between the structures 122 arranged in the second direction is greater than or equal to 10 times the interval D6.

As illustrated in FIG. 9(d), in this example, two types of intervals D5 and D6 are disposed between the adjacent structures 122. For this reason, it is possible to diffract light having at least two types of wavelengths at diffraction angles which are identical to each other. That is, extraction efficiency of the light having at least two types of wavelengths is able to be improved.

In this example, the same effect as that of Example 1 described above is able to be obtained.

That is, in the plane intersecting with the light transmissive substrate 110, the plurality of structures 122 forming one diffraction grating 123 are periodically arranged in the first direction (the direction of an arrow A1) intersecting with the light transmissive substrate 110, and are arranged by being distributed in the second direction (the direction of an arrow A2) intersecting with the first direction. For this reason, the wall-like diffraction grating 123 is formed by the plurality of structures 122. Accordingly, the light having a direction intersecting with the wall surface formed by the diffraction grating 123 is incident on the diffraction grating 123, and thus a part of the light is able to be extracted to the light emission space by diffracting the light. In addition, the two types of intervals D5 and D6 are disposed between the adjacent structures 122, and thus extraction efficiency of the light having at least two types of wavelengths is able to be improved.

### (Example 3)

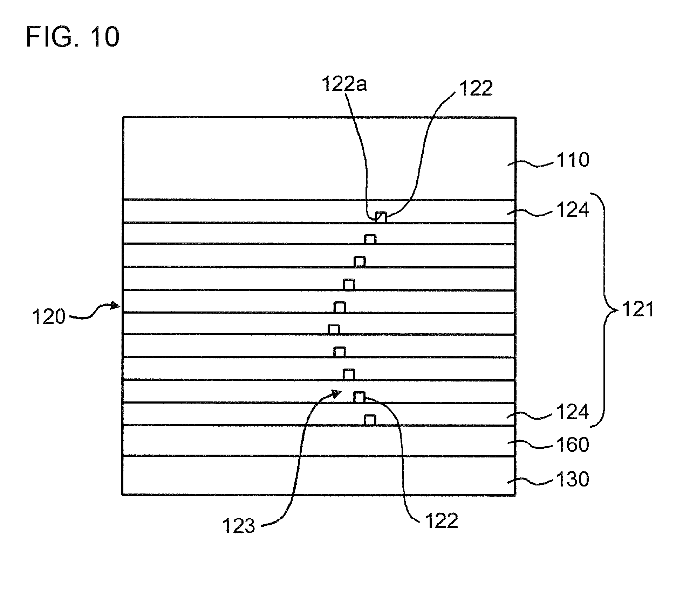

FIG. 10 is a cross-sectional view of a main part of the light emitting element 100 according to Example 3. The light emitting element according to this example is different from the light emitting element 100 according to Example 1 described above (FIG. 5 to FIG. 7) in the structure of the diffraction grating 123, and the other configuration is identical to that of the light emitting element 100 according to Example 1 described above.

The diffraction grating 123 has wavelength dependence properties with respect to light which is able to be diffracted. For this reason, when light having a plurality of wavelengths is used as a target (for example, when the light emitting element 100 emits white light, or the like), as illustrated in FIG. 10, the positions of the concave portions 122a of the light transmissive films 124 in the adjacent layers are gradually shifted from each other, and thus the interval between the structures 122 is able to be longer than that in Example 1 described above. As a result thereof, light having more colors is able to be diffracted by the diffraction grating 123.

Furthermore, it is preferable that a plurality of types of diffraction gratings 123 having intervals between the adjacent structures 122 different from each other are mixed in the diffraction grating layer 120. Accordingly, for example, light having wavelengths which are different from each other may be diffracted for each diffraction grating 123 such that red light is mainly diffracted by one diffraction grating 123, and blue light is mainly diffracted by the other diffraction grating 123.

In addition, in this example, the positions of the concave portions 122a of the light transmissive films 124 in the respective layers are shifted from each other, and thus when the concave portion 122a is formed by performing the imprinting with respect to the light transmissive film 124, it is possible to prevent a configuration material of the light transmissive films 124 in the respective layers from protruding in the concave portion 122a of the adjacent light transmissive film 124.

Furthermore, a film thickness of each layer of the light transmissive films 124 is thicker than that in Example 1 described above, and thus it is possible to make the interval between the structures 122 longer than that in Example 1 described above.

### (Example 4)

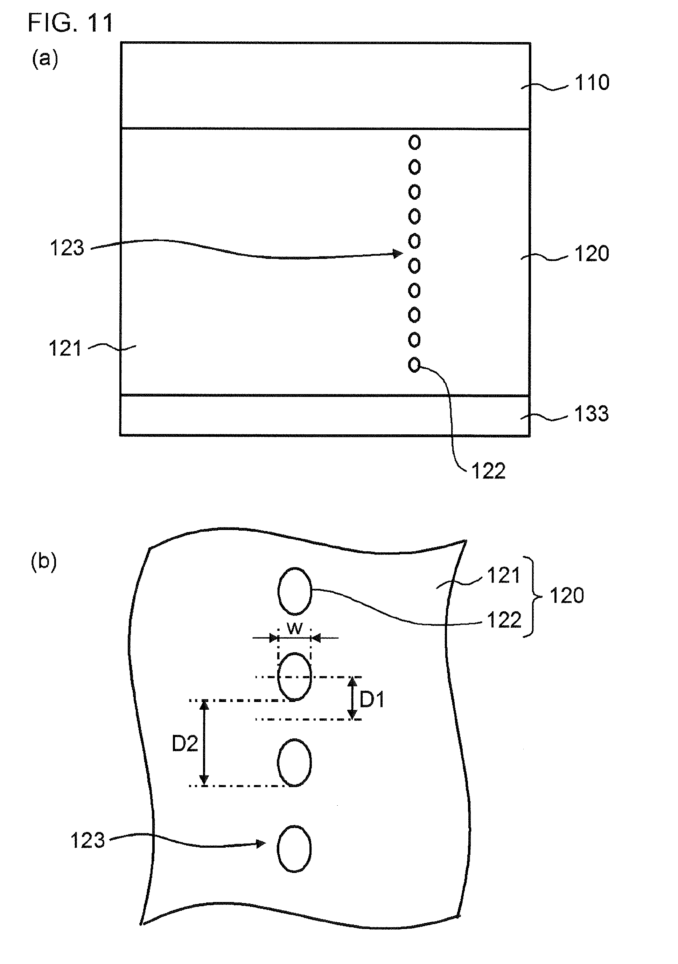

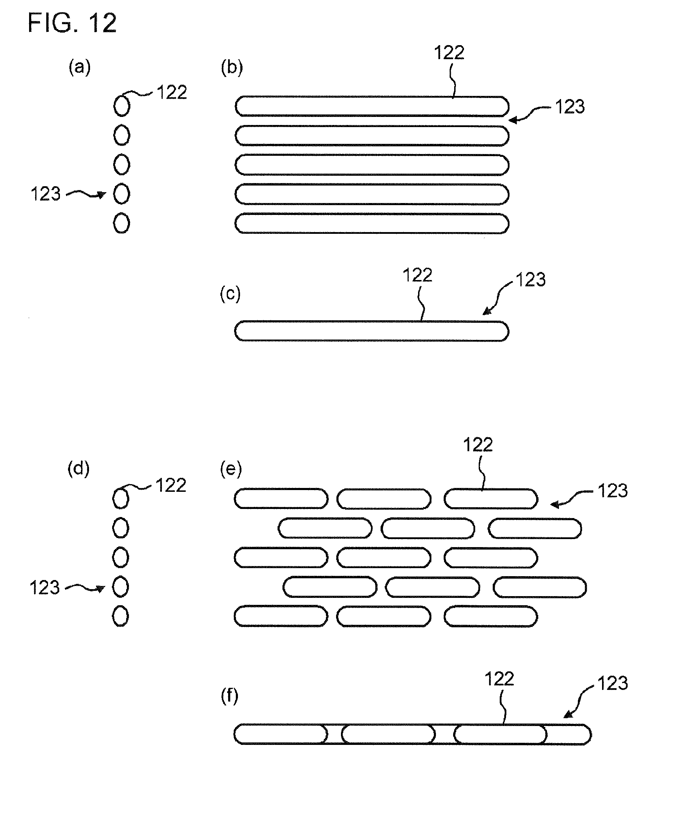

FIG. 11(a) is a cross-sectional view of a main part of a light emitting element according to Example 4, and FIG. 11 (b) is an enlarged view of a main part of FIG. 11 (a). FIGS. 12 (a) to 12 (c) are diagrams illustrating a first example of the diffraction grating 123 of the diffraction grating layer 120 of the light emitting element according to Example 4, in which FIG. 12(a) is a side cross-sectional view, FIG. 12(b) is a front view, and FIG. 12(c) is a plan view. FIGS. 12(d) to 12(f) are diagrams illustrating a second example of the diffraction grating 123 of the diffraction grating layer 120 of the light emitting element according to Example 4, in which FIG. 12(d) is a side cross-sectional view, FIG. 12 (e) is a front view, and FIG. 12(f) is a plan view. The light emitting element according to this example is different from the light emitting element 100 according to Example 1 described above in the following description, and the other configuration is identical to that of the light emitting element 100 according to Example 1 described above.

The base portion 121 of the diffraction grating layer 120, for example, is formed of an organic material used in a DVD, a CD, or the like such as a phthalocyanine-based material or an azo-based material, and an organic material such as N,N-di(naphthalene-1-yl)-N,N-diphenyl-benzidene (NPB). The base portion 121, for example, is a dielectric layer.

The structure 122 is configured by irradiating a part of the base portion 121 with a light ray of laser light or the like for heating the part, to change the refractive index of the part. The refractive index of the structure 122 may be smaller than the refractive index of the base portion 121, or may be greater than the refractive index of the base portion 121.

When the part of the base portion 121 is continuously irradiated with the laser light at a constant intensity, change in the refractive index due to temperatures may vary depending on the location, so that the irradiation may be pulsed at minute intervals such that the refractive index becomes constant. In addition, an irradiation time of the laser light may be changed for each pulse by using a signal in which a pulse having a width which is sequentially changed is superimposed on a direct current as a driving signal (a driving current) of the laser emitting the laser light.

The shape of the structure 122 is arbitrary. Since the structure 122 is formed by the irradiation of the light ray, as in the first example illustrated in FIGS. 12(a) to 12(c) or in the second example illustrated in FIGS. 12 (d) to 12 (f), the structure 122, for example, is in the shape of a cylinder or an elliptic cylinder (the cross-section is in the shape of a circle or an ellipse). Furthermore, the first example illustrated in FIGS. 12(a) to 12(c) illustrates an example in which the structure 122 having the same shape and the same arrangement as that in Example 1 described above (FIGS. 7(a) to 7(c)) is formed by the irradiation of the light ray. In addition, the second example illustrated in FIGS. 12(d) to 12(f) illustrates an example in which the structure 122 has the same shape and the same arrangement as that in Example 2 described above (FIGS. 9 (a) to 9 (d)).

For example, a refractive index difference between the structure 122 and the base portion 121 gradually increases towards the inside of the structure 122 from a boundary between the structure 122 and the base portion 121. That is, the refractive index of the structure 122, for example, increases or decreases towards the inside of the structure 122 from the boundary between the structure 122 and the base portion 121.

When a material having a refractive index which is decreased by heating is used as a material of the base portion 121, by heating a part of the diffraction grating layer 120, it is possible to decrease a refractive index of the heated portion. As an example of such a material, an organic material used in a DVD, a CD, or the like such as a phthalocyanine-based material or an azo-based material is included.

In addition, when a material having a refractive index which is increased by heating is used as the material of the base portion 121, by heating and thereafter cooling a part of the diffraction grating layer 120, the heated portion is crystallized, and thus it is possible to increase a refractive index of the heated portion. As an example of such a material, NPB used as the material of the organic functional layer 140 is included.

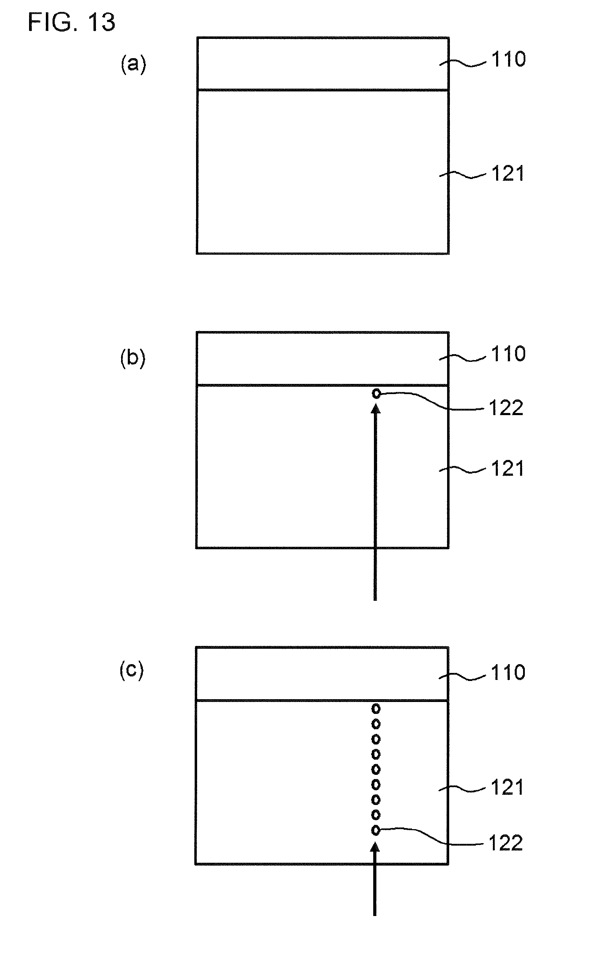

Next, in a method of manufacturing a light emitting element according to this example, a step of forming the diffraction grating layer 120 will be described. FIGS. 13(a) to 13(c) are diagrams for illustrating the method of manufacturing a light emitting element according to this example.

In this example, the step of forming the diffraction grating layer 120 includes a step of forming the base portion 121, and a step of irradiating a part of the base portion 121 with a light ray to change a refractive index of the part to a refractive index different from that of the base portion 121, to thereby form the part into the structure 122.

First, as illustrated in FIG. 13(a), an organic film which becomes the base portion 121 is formed on the lower surface of the light transmissive substrate 110.

Next, as illustrated in FIGS. 13(b) and 13(c), a part of the base portion 121 is irradiated with a light ray of laser light or the like. Accordingly, the part is heated to change the refractive index of the part to a refractive index different from that of the base portion 121. Accordingly, the part is able to be formed into the structure 122.

By heating the part of the diffraction grating layer 120, a molecular structure of the material configuring the diffraction grating layer 120 is changed, or a dense distribution of the material configuring the diffraction grating layer 120 is changed, and thus the refractive index of the part is changed. Here, a light intensity distribution of the emitted laser light or the like is a Gaussian distribution, and intensity of the center portion in an irradiation spot of the light increases. For this reason, an influence on the molecular structure or the dense distribution of the material configuring the diffraction grating layer 120 increases towards the center of the irradiation spot. Accordingly, the refractive index of the structure 122, for example, gradually decreases or increases towards the center of the irradiation spot.

Here, in an irradiation direction of the light ray, the structure 122 is formed sequentially from the back (as illustrated in FIGS. 13(b) and 13(c), from an upper side when the light ray is emitted from a lower side), and thus it is possible to form the plurality of structures 122 to be arranged in a direction identical to the irradiation direction of the light ray. At this time, by gradually changing a focus position of the light ray at the time of forming each of the structures 122, it is possible to form each of the structures 122 in a desired position (depth).

Furthermore, in this example, the diffraction grating layer 120 is not formed by laminating a plurality of thin films (the light transmissive films 124) as in Example 1 described above, but the diffraction grating layer 120 (the base portion 121) is formed by one layer of the organic material, and thus it is possible to easily form the diffraction grating layer 120 to be flat. Therefore, for the objective of flattening, the barrier film 160 may not be formed. However, the barrier film 160 may be formed for suppressing the influence on the organic material.

The other step is identical to that in Example 1 described above, and thus the description will not be repeated.

Here, the light ray may be emitted from a lower surface side of the base portion 121 (a side opposite to the light transmissive substrate 110), or may be emitted to the base portion 121 through the light transmissive substrate 110.

In addition, a timing of forming the structure 122 by irradiating the base portion 121 with the light ray is able to be an arbitrary timing after the base portion 121 is formed.

When the structure 122 is formed after the base portion 121 is formed and before the first electrode 130 is formed, the light ray may be emitted from any surface side of the base portion 121.

In addition, when the structure 122 is formed after the first electrode 130 is formed, when the structure 122 is formed after the first electrode 130 and the organic functional layer 140 are formed, or when the structure 122 is formed after the first electrode 130, the organic functional layer 140, and the second electrode 150 are formed, it is preferable that the base portion 121 is irradiated with the light ray through the light transmissive substrate 110 in order to suppress damage to the first electrode 130 or the organic functional layer 140.

When the laser light is used as the light ray, by using a femtosecond laser or a nanosecond laser, it is possible to suppress damage caused by the laser light to the first electrode 130 or the organic functional layer 140. However, when the light ray is emitted before the first electrode 130 or the organic functional layer 140 is formed, since it is not necessary to consider the damage to the first electrode 130 or the organic functional layer 140, a CW laser (continuous wave oscillation operation laser) or a pulse laser may be used.

Furthermore, the structure 122 may be formed after the second electrode 150 is formed, sealing is completed, and a light emitting device having a panel structure which includes the light emitting element 100 is formed. In this case, the light is emitted from the light transmissive substrate 110 side.

In addition, one structure 122 may be formed by performing the irradiation of the laser light once, or irradiation may be performed with respect to small regions a plurality of times to form one structure 122 by an aggregate of these regions.

Furthermore, the light ray emitted for forming the structure 122 is not limited to the laser light. For example, the structure 122 is also able to be formed by transmitting strong light having a single wavelength, other than the laser, emitted through a mask and collected by a lens, and performing image formation with respect to a part of the diffraction grating layer 120. In this case, a wider region than when using the laser light can be subjected to a heat treatment at one time.

According to this example, the step of forming the diffraction grating layer 120 includes the step of forming the base portion 121, and the step of irradiating the part of the base portion 121 with the light ray to change the refractive index of the part to the refractive index different from that of the base portion 121, to thereby form the part into the structure 122. Accordingly, the irradiation position or the intensity of the light ray is suitably changed, and thus it is possible to easily form the structure 122 with a desired size in a desired position.

### (Example 5)

FIG. 14(a) is a plan view of the light emitting element 100 according to Example 5, and FIG. 14 (b) is a cross-sectional view taken along line B-B of FIG. 14(a). In this example, a more specific configuration example of the light emitting element according to Example 4 above will be described. Furthermore, FIG. 14 (b) and FIG. 11(a) are vertically inverted from each other.

The diffraction grating layer 120 including the base portion 121 and the structure 122 is formed on the light transmissive substrate 110. The first electrode 130 is formed on the diffraction grating layer 120. The first electrode 130 configures a anode. Each of a plurality of first electrodes 130 extends in a Y direction in the shape of a strip. The adjacent first electrodes 130 are separated at constant intervals in an X direction orthogonal to the Y direction. Each of the first electrodes 130, for example, is formed of a metal oxide conductor or the like of ITO, IZO, and the like. The refractive index of the first electrode 130 is approximately identical to that of the diffraction grating layer 120 (for example, a refractive index of approximately 1.8). The bus line (a bus electrode) 170 for supplying an electric power source voltage to the first electrode 130 is formed on a surface of each of the first electrodes 130. An insulating film is formed on the light transmissive substrate 110 and the first electrode 130. A plurality of stripe-patterned opening portions extending in the Y direction is formed on the insulating film. Accordingly, a plurality of partition wall portions 180 formed of an insulating film is formed. In addition, each of the opening portions formed in the insulating film reaches the first electrode 130, and the surface of the first electrode 130 is exposed in a bottom portion of the opening portion. In each of the opening portions of the insulating film, the organic functional layer 140 is formed on the first electrode 130. The organic functional layer 140 is configured by laminating the hole injection layer 141, the hole transport layer 142, the light emitting layer 143 (the light emitting layers 143R, 143G, and 143B), and the electron transport layer 144 in this order. As a material of the hole injection layer 141 and the hole transport layer 142, an aromatic amine derivative, a phthalocyanine derivative, a porphyrin derivative, an oligothiophene derivative, a polythiophene derivative, a benzyl phenyl derivative, a compound connecting a tertiary amine by a fluorene group, a hydrazone derivative, a silazane derivative, a silanamine derivative, a phosphamine derivative, a quinacridone derivative, a polyaniline derivative, a polypyrrole derivative, a polyphenylene vinylene derivative, a polythienylene vinylene derivative, a polyquinoline derivative, a polyquinoxaline derivative, carbon, and the like are included. Each of the light emitting layers 143R, 143G, and 143B is formed of a fluorescent organic metal compound or the like which emits red light, green light, and blue light, respectively. The light emitting layers 143R, 143G, and 143B are arranged in a state of being separated from each other by the partition wall portion 180. That is, the organic functional layer 140 is partitioned into a plurality of regions by the partition wall portion 180. The electron transport layer 144 is formed to cover surfaces of light emitting layers 143R, 143G, and 143B, and the partition wall portion 180. The second electrode 150 is formed to cover a surface of the electron transport layer 144. The second electrode 150 configures a cathode. The second electrode 150 is formed in the shape of a strip. The second electrode 150 is formed of metal such as Ag, Au, and Al, or an alloy thereof, and the like having a low work function and a high reflection ratio. Furthermore, the refractive index of the organic functional layer 140 is approximately identical to that of the first electrode 130 and the diffraction grating layer 120 (for example, a refractive index of approximately 1.8).

Thus, the light emitting layers 143R, 143G, and 143B which respectively emit the red light, the green light, and the blue light are repeatedly arranged in a striped pattern. Light recognized as a single emission color (for example, a white color) obtained by mixing the red light, the green light, and the blue light at an arbitrary ratio is emitted from the surface of the light transmissive substrate 110 which is the light extraction surface.

In this example, the same effect as that of Example 4 described above is able to be obtained.

### (Example 6)

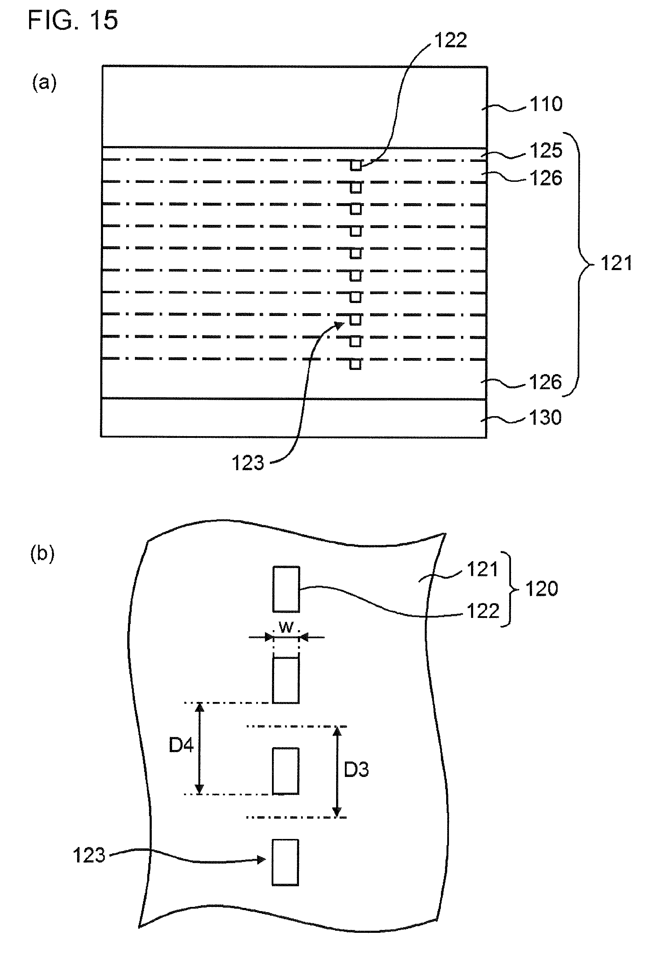

FIG. 15(a) is a cross-sectional view of a main part of a light emitting element according to Example 6, and FIG. 15 (b) is an enlarged view of a main part of FIG. 15(a). The light emitting element according to this example is different from the light emitting element 100 according to Example 1 described above in the following description, and the other configuration is identical to that of the light emitting element 100 according to Example 1 described above.

In this example, each of the plurality of structures 122 of the diffraction grating layer 120 is configured of metal.

Here, the diffraction of the light occurs due to a phase difference between the adjacent light paths. The metal does not transmit the light, and thus, in this example, an interval between the adjacent light paths is different from that in Example 1. Accordingly, in this example, the interval between the structures 122 is set to be a distance different from that of Example 1.

An interval D3 illustrated in FIG. 15 (b) is an interval between lights which are adjacent to each other among lights which proceed in a direction (a right and left direction in FIG. 15 (b)) orthogonal to the diffraction grating 123 and passes through the center of the interval between the adjacent structures 122. In addition, an interval D4 corresponds to the interval D2 (FIG. 2) in Example 1. In this example, the diffraction angle increases as the interval D3 becomes closer to the wavelength. The interval D3, for example, is set to be greater than or equal to 310 nm which is a peak wavelength of the base portion 121 (for example, the interval D3 is 400 nm).

In addition, in this example, the interval D4 between the adjacent structures 122 is identical to the interval D3, and thus the interval D4, for example, is also 400 nm.

Furthermore, similar to Example 1; the width W, for example, is set to be 160 nm.

In this example, by using the diffraction grating 123 which is set in this way, it is possible to realize the same operation as that in Example 1.

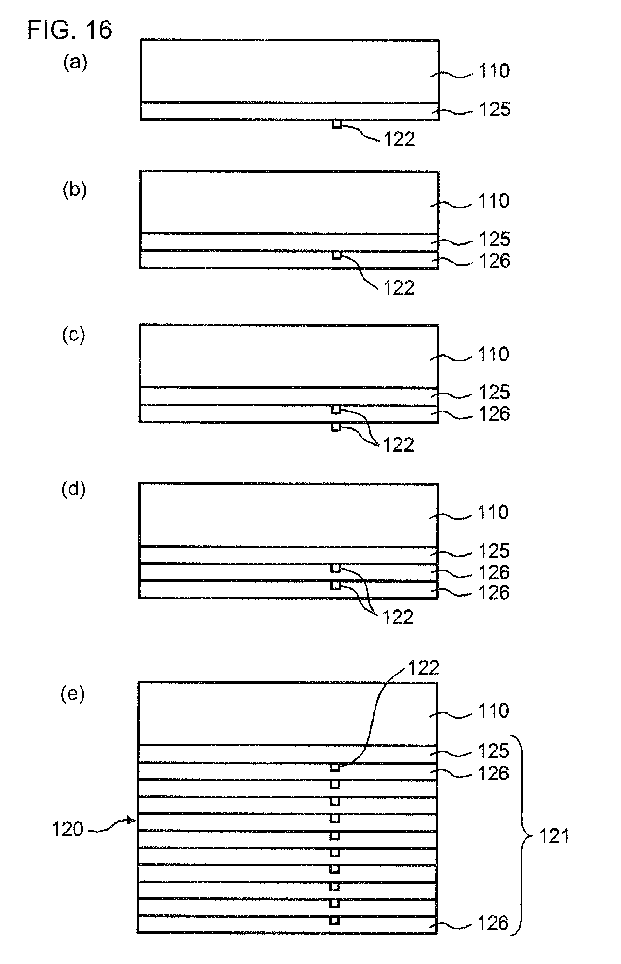

Next, in a method of manufacturing a light emitting element according to this example, a step of forming the diffraction grating layer 120 will be described. FIGS. 16(a) to 16(e) are diagrams for illustrating the method of manufacturing a light emitting element according to Example 5.

In this example, in the step of forming the diffraction grating layer 120, a step of forming the structure 122 of the metal and a step of forming a light transmissive layer 126 such that the structure 122 is embedded in the light transmissive layer 126 are alternately repeated, and thus the base portion 121 is formed by a plurality of layers of the light transmissive layer 126 each including the structure 122 therein.

First, as illustrated in FIG. 16 (a), a light transmissive layer 125 is formed on one surface of the light transmissive substrate 110 (a lower surface in FIG. 16(a)). The light transmissive layer 125, for example, is configured of an organic material. Next, the first layer of the structure 122 formed of the metal is formed on one surface of the light transmissive layer 125 (a lower surface in FIG. 16 (a)). The structure 122, for example, is able to be formed by depositing the metal through a mask using vapor deposition.

Next, as illustrated in FIG. 16(b), a first layer of the light transmissive layer 126 is formed on the one surface of the light transmissive layer 125 by embedding the first layer of the structure 122 in the light transmissive layer 126. A material of the light transmissive layer 126 is identical to that of the light transmissive layer 125.

Next, as illustrated in FIG. 16 (c), for example, the second layer of the structure 122 is formed on one surface of the light transmissive layer 126 (a lower surface in FIG. 16(c)) by depositing the metal through the mask using vapor deposition. Next, as illustrated in FIG. 16(d), a second layer of the light transmissive layer 126 is formed on one surface of the first layer of the light transmissive layer 126 by embedding the first layer of the structure 122 in the second layer of the light transmissive layer 126.

Hereinafter, similarly, a step of forming the structure 122 of the metal and a step of forming the light transmissive layer 126 are alternately repeated. Accordingly, as illustrated in FIG. 16(e), the base portion 121 is formed by a plurality of layers of the light transmissive layer 126 each including the structure 122 therein.

Furthermore, since each of the light transmissive layer 126 and the light transmissive layer 125 are formed of materials identical to each other, a boundary surface does not substantially exist between each of the light transmissive layer 126 and the light transmissive layer 125 (refer to FIG. 15(a)).

Furthermore, herein, an example is described in which the light transmissive layer 125 is formed on the one surface of the light transmissive substrate 110, and then the first layer of the structure 122 is formed on the light transmissive layer 125. However, the first layer of the structure 122 may be directly formed on the one surface of the light transmissive substrate 110.

According to this example, the structure 122 is configured of the metal, and thus the structure 122 is easily formed at a desired interval and in a desired shape by suitably setting conditions for forming the structure 122 (conditions of the vapor deposition) or the like, and it is possible to easily form the diffraction grating 123 having a desired structure.

In addition, in the step of forming the diffraction grating layer 120, the step of forming the structure 122 of the metal and the step of forming the light transmissive layer 126 such that the structure 122 is embedded in the light transmissive layer 126 are alternately repeated, and thus the base portion 121 is formed by the plurality of layers of the light transmissive layer 126 each including the structure 122 therein. Accordingly, the structure 122 is easily formed at a desired interval and in a desired shape by suitably setting the conditions for forming the structure 122 (the conditions of the vapor deposition) or the like, and thus it is possible to easily form the diffraction grating 123 having a desired structure.

### (Example 7)

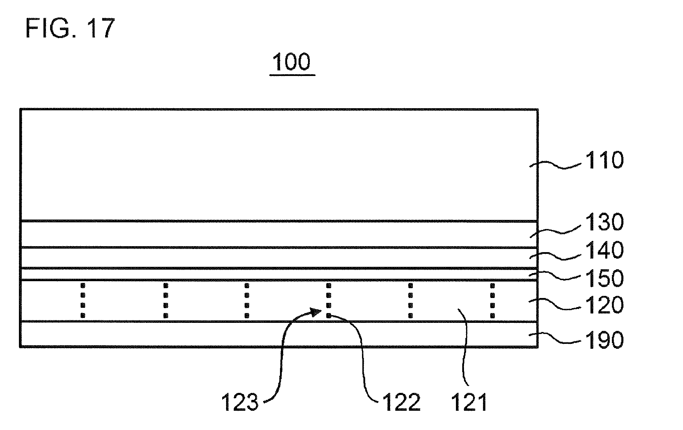

FIG. 17 is a cross-sectional view of a light emitting element according to Example 7. The light emitting element 100 according to this example is different from the light emitting element 100 according to Example 1 described above in the following description, and the other configuration is identical to that of the light emitting element 100 according to Example 1 described above.

In Example 1 described above, an example is described in which the diffraction grating layer 120 is arranged between the light transmissive substrate 110 and the light emitting layer. On the other hand, in this example, the diffraction grating layer 120 is arranged on a side opposite to the light transmissive substrate 110 based on the light emitting layer. Further, the light emitting element 100 according to this embodiment includes a light reflective layer 190. The light reflective layer 190 is arranged on a side opposite to the light transmissive substrate 110 based on the diffraction grating layer 120, and reflects light arriving from the diffraction grating layer 120 side.

More specifically, the diffraction grating layer 120 is arranged on the side opposite to the light transmissive substrate 110 based on the second electrode 150.

In this example, the second electrode 150 is not a reflective electrode, but is a light transmissive electrode. The second electrode 150, for example, may be a thin metal film which is thin to the extent of transmitting the light, or may be a transparent electrode formed of a metal oxide conductor of ITO, IZO, and the like. However, it is necessary to make the size of a work function of the material of the first electrode 130 different from the size of a work function of the material of the second electrode 150.

In addition, the light reflective layer 190, for example, is formed of a metal film of Ag, Au, Al, and the like. The light reflective layer 190 reflects the light which is directed from the light emitting layer towards the light reflective layer 190 side, towards the light transmissive substrate 110 side.

In this embodiment, a mechanism of improving light extraction efficiency by the diffraction grating 123 of the diffraction grating layer 120 is identical to that in Example 1. That is, the direction of a part of the higher-order light generated by diffraction by the diffraction grating 123 is able to be changed to a direction in which the light is extracted to the light emission space from the light emitting element 100.

In this example, the structure 122 can also be formed by the irradiation of the light ray of the laser light or the like. In this case, in order to suppress the damage to the organic functional layer 140 and the first electrode 130, it is preferable that the light ray is emitted from a lower side in FIG. 17. Thus, the second electrode 150 becomes a mask, and thus it is possible to suppress the damage to the organic functional layer 140. Accordingly, a CW laser or a pulse laser is able to be used. In addition, the light reflective layer 190 may be formed before the irradiation of the light ray (before forming the structure 122), or may be formed after the irradiation of the light ray (after forming the structure 122). Alternatively, the light reflective layer 190 may be formed twice, before and after the irradiation of the light ray.

According to this example, the diffraction grating layer 120 is arranged on the side opposite to the light transmissive substrate 110 based on the light emitting layer, and thus the direction of the part of the light which is directed from the light emitting layer towards the side (the light reflective layer 190 side) opposite to the light transmissive substrate 110 is able to be changed by the diffraction grating 123, and the light is able to be extracted to the outside from the light emitting element 100.

### (Example 8)

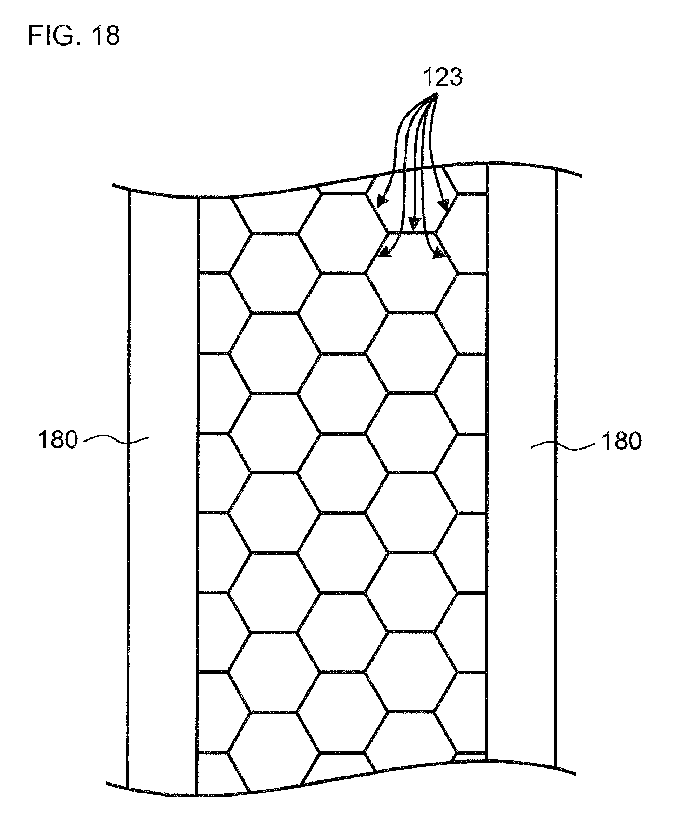

FIG. 18 is a plan view of a light emitting element according to Example 8. Furthermore, in FIG. 18, for the sake of easily understating the drawing, only the diffraction grating 123 and the partition wall portion 180 are illustrated. The light emitting element 100 according to this example is different from the light emitting element 100 according to Example 1 described above in the following description, and the other configuration is identical to that of the light emitting element 100 according to Example 1 described above.

In Example 1 described above, an example is described in which the plurality of wall-like diffraction gratings 123 are arranged in the shape of a square (for example, rectangular) grating in a plan view. However, the arrangement of the plurality of wall-like diffraction gratings 123 is not limited to the shape of a square grating in a plan view. For example, as illustrated in FIG. 18, the arrangement may be in the shape of a grating (a honeycomb) which is configured by arranging a plurality of hexagons without intervals. Alternatively, the arrangement may be in the shape of a triangular grating or other polygonal gratings. In addition, the arrangement may have a plurality of types of polygonal gratings such as a square grating, a triangular grating, and a hexagonal grating mixed therein. In addition, the arrangement may be in a shape including a curved line such as a circle, or may be mixed with this shape.

In this example, a probability that light having various directions in a plan view becomes incident on any of the diffraction gratings 123 increases, compared to Example 1. As a result thereof, it is possible to further increase light extraction efficiency compared to Example 1 described above.

As described above, the embodiments and the examples are described with reference to the drawings. The embodiments and the examples are exemplifications of the present invention, and various configurations other than the configurations described above are able to be adopted.

For example, in Example 1 described above, an example is described in which the diffraction grating layer 120 is arranged between the light transmissive substrate 110 and the light emitting layer, and in Example 7 described above, an example is described in which the diffraction grating layer 120 is arranged on the side opposite to the light transmissive substrate 110 based on the light emitting layer. However, the diffraction grating layer 120 may be arranged in the both of, between the light transmissive substrate 110 and the light emitting layer, and on the side opposite to the light transmissive substrate 110 based on the light emitting layer. In this case, similar to Example 7, the light reflective layer 190 is formed.

Furthermore, it is not necessary that the respective constituents in the respective embodiments described above independently exist. A plurality of constituents may be formed as one member, one constituent may be formed of a plurality of members, one constituent may be a part of the other constituent, or a part of one constituent may overlap with a part of the other constituent.

For example, in all of the embodiments and the examples, an example is described in which the diffraction grating layer 120 formed of a material different from that of the light transmissive substrate 110 is formed on the light transmissive substrate 110, and the material of the light transmissive substrate may be a base material of the diffraction grating layer by making the thickness of the light transmissive substrate thin. That is, a part of a layer formed of the same type of material may function as the light transmissive substrate, and the other part of the layer may function as the diffraction grating layer. Further, a part of the layer formed of the same type of material may function as the light transmissive substrate, another part of the layer may function as the diffraction grating layer, and still another part of the layer may function as the light extraction film.

## Claims

1. A light emitting element, comprising:
a light transmissive substrate;
a light emitting layer arranged on a side opposite to a light extraction side based on the light transmissive substrate; and
a diffraction grating layer arranged on a side opposite to the light extraction side based on the light transmissive substrate,
wherein the diffraction grating layer includes
a light transmissive base portion, and
a plurality of structures which are periodically arranged in a direction intersecting with the light transmissive substrate to thereby form a diffraction grating in the base portion.

2. The light emitting element according to Claim 1,
wherein a refractive index of the base portion is greater than a refractive index of the light transmissive substrate and less than or equal to 2.3.

3. The light emitting element according to Claim 1 or 2,
wherein the diffraction grating layer includes a plurality of the diffraction gratings which are arranged by being separated from each other in a plan view.

4. The light emitting element according to any one of Claims 1 to 3,
wherein the diffraction grating layer is arranged between the light transmissive substrate and the light emitting layer.

5. The light emitting element according to any one of Claims 1 to 3,
wherein the diffraction grating layer is arranged on a side opposite to the light transmissive substrate based on the light emitting layer, and
the light emitting element further comprises a light reflective layer which is arranged on a side opposite to the light transmissive substrate based on the diffraction grating layer, and reflects light arriving from the diffraction grating layer side.

6. The light emitting element according to any one of Claims 1 to 5,
wherein the structure has a refractive index different from that of the base portion.

7. The light emitting element according to any one of Claims 1 to 6,wherein each of the plurality of structures forming one said diffraction grating extends in parallel with the light transmissive substrate, and is arranged in parallel with each other.

8. The light emitting element according to any one of Claims 1 to 6,
wherein the plurality of structures forming one said diffraction grating are periodically arranged in a first direction intersecting with the light transmissive substrate, and are arranged by being distributed in a second direction intersecting with the first direction, in a plane intersecting with the light transmissive substrate, and
the plurality of structures are arranged such that an interval between the structures in a row of the plurality of structures which are arranged in the second direction is occupied by the structure in the adjacent row when the one diffraction grating is viewed from the first direction.

9. The light emitting element according to any one of Claims 1 to 8,
wherein the structure is configured of metal.

10. A method of manufacturing a light emitting element, comprising:
a step of forming a light emitting layer on a side opposite to a light extraction side based on a light transmissive substrate; and
a step of forming a diffraction grating layer on a side opposite to the light extraction side based on the light transmissive substrate,
wherein in the step of forming the diffraction grating layer, the diffraction grating layer is formed including a light transmissive base portion, and a plurality of structures which are periodically arranged in a direction intersecting with the light transmissive substrate to thereby form a diffraction grating in the base portion.

11. The method of manufacturing a light emitting element according to Claim 10,
wherein the step of forming the diffraction grating layer includes
a step of forming the base portion, and
a step of irradiating a part the base portion with a light ray to change a refractive index of the part to a refractive index different from that of the base portion, to thereby form the part into the structure.

12. The method of manufacturing a light emitting element according to Claim 10,
wherein in the step of forming the diffraction grating layer,
a step of forming a light transmissive film configuring a part of the base portion, and
a step of forming a concave portion configuring the structure by performing imprinting with respect to the light transmissive film,
are alternately repeated to form the base portion by a plurality of layers of the light transmissive film each including the structure therein.

13. The method of manufacturing a light emitting element according to Claim 10,
wherein in the step of forming the diffraction grating layer,
a step of forming the structure of metal, and
a step of forming the light transmissive layer such that the structure is embedded in the light transmissive layer,
are alternately repeated to form the base portion by a plurality of the light transmissive layers each including the structure therein.
